# EUROPEAN PATENT APPLICATION

(11) **EP 2 439 441 A2**
(43) Date of publication of application: **11.04.2012**
(21) Application number: 10197243.8
(22) Date of filing: 29.12.2010
(51) Int. Cl.: F21K 99/00, F21V 7/00, F21Y 101/02

(54) **Complementary color light source device**

(30) Priority: 05.10.2010 TW 099133919
(71) Applicant: Advanced Connectek Inc., Taipei Hsien Hsin-Tien (TW)
(72) Inventor: Yu, Chung-Hung, Taipei (TW); Chaoi, Ta-Wei, Taipei (TW); Pan, Chien-Nan, Taipei (TW)
(74) Representative: Lang, Christian

(57) **Abstract**

The invention provides a complementary color light source device (2), which comprises a light emitting unit (1), a mask (4) and a complementary color film layer (6). The mask (4) comprises a hollow portion (42), and the hollow portion (42) contains the light emitting unit (1). The complementary color film layer (6) is uniformly attached to a side of the mask (4), and a part of the first wavelength light generated by the light emitting unit (1) passes through the complementary color film layer (6) to generate a second wavelength light. The second wavelength light and the first wavelength light generated by the light emitting unit (1) are color mixed to generate white light. The invention provides the first wavelength light generated by the light emitting unit to transform to the second wavelength light with complementary color, and color mixing both lights to achieve a light source device with low cost, high light emission efficiency, high service life and high color rendering index.

## Description

### FIELD OF THE INVENTION

The present invention relates to a complementary color light source device, and particularly to utilize a mask having a complementary color film layer to generate a second wavelength light, and color mixing the second wavelength light and a first wavelength light generated by the light emitting unit to generate white light.

### BACKGROUND

With the worldwide environmental protection trend of energy saving and carbon emission deduction, the energy saving light emission devices are widely utilized, and it is a fashion to use the light emitting diode (LED) as the light source.

A conventional white light LED utilizes color mixing of two or three light sources with different wavelength to obtain the white light LED. For example, a blue light LED can pair up with complementary yellow fluorescent particles, or the blue light LED can pair up with both complementary red fluorescent particles and green fluorescent particles, and a combination of the fluorescent particles and the blue light LED can be tightly packed together in a packaging process to obtain the white light LED. Such manufacturing technique of the white light LED is disclosed in the Taiwan Patent No. I329 368 and the U.S. Patent No. 5,959,316.

In the example, the fluorescent particles and the blue light LED can be tightly packed together, so when the blue light LED performs combination of an electron-hole pair, it generates high heat and directly reduces the service life of the fluorescent particles, thus reducing the service life of the white light LED.

Therefore, there is a need for a device to solve the aforementioned problems and to achieve the objective of a white light LED with high service life.

### SUMMARY OF THE INVENTION

An objective of the present invention is to provide a complementary color light source device, which provides a first wavelength light generated by a light emitting unit and transforms one part of the first wavelength light to a second wavelength light, and color mixing the other part of the first wavelength light and the second wavelength light to generate white light, thus achieving a light source device with low cost, high light emission efficiency, high service life and high color rendering index.

To achieve the foregoing objectives of the invention, the invention provides a complementary color light source device, which comprises a light emitting unit, a mask and a complementary color film layer. The light emitting unit is configured to generate a first wavelength light. The mask comprises a hollow portion, and the hollow portion contains the light emitting unit. The complementary color film layer is uniformly attached to a side of the mask, and a part of the first wavelength light generated by the light emitting unit passes through the complementary color film layer to generate a second wavelength light which is complementary to the colors of the first wavelength light.

Comparing to the related arts, the complementary color light source device provides the mask with the complementary color film layer to the light emitting unit, and does not require packing the light emitting unit together with fluorescent particles in a packaging process. The invention can be utilized in a light emitting unit which is packed or epitaxial die and belongs to secondary optical elements of packed LEDs. In addition, to obtain the second wavelength light, there is no need to pack the fluorescent particles and sealing glue together with the light emitting unit. In the invention, the complementary color film layer is distant from the packing layer of the LED so that the fluorescent particles will not become deteriorated due to the high heat generated by the LED, and the light emission efficiency of the white light will increase after color mixing. Thus, comparing to the related arts, the invention has the advantage of low cost, high light emission efficiency, high service life and high color rendering index.

### BRIEF DESCRIPTION OF THE DRAWINGS

Fig. 1 is a schematic view of a complementary color light source device according to an embodiment of the invention;

Fig. 2 is a schematic view of a complementary color light source device according to another embodiment of the invention;

Fig. 3 is a schematic view of a complementary color light source device according to a further embodiment of the invention;

Fig. 4 is a schematic view of a complementary color light source device according to another embodiment of the invention; and

Fig. 5 is a schematic view of a complementary color light source device according to a further embodiment of the invention.

### DETAILED DESCRIPTION OF THE INVENTION

The techniques employed by the present invention to achieve the foregoing objectives and the effects thereof are described hereinafter by way of examples with reference to the accompanying drawings.

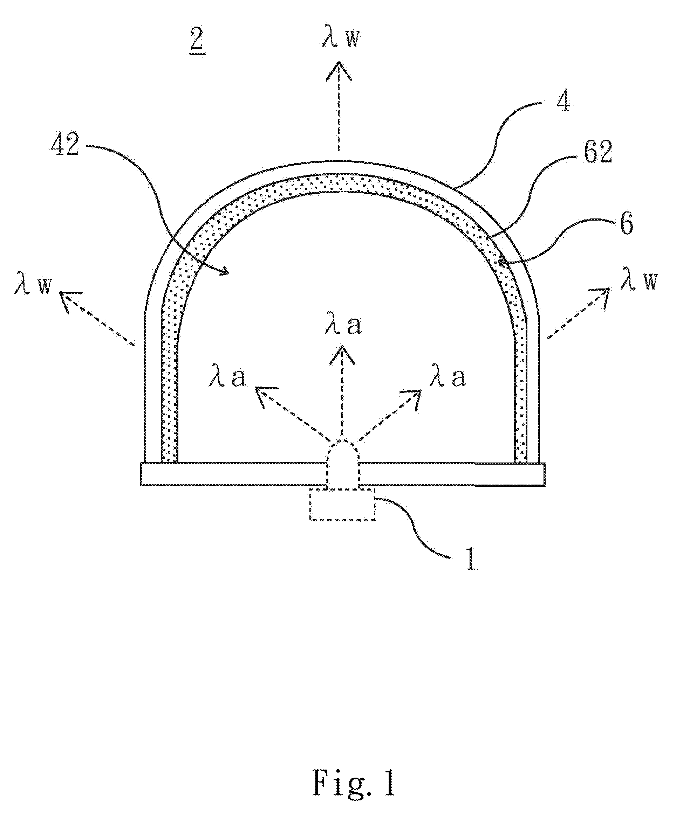

Referring to Fig. 1, which is a schematic view of a complementary color light source device according to an embodiment of the invention. In Fig. 1, the complementary color light source device 2 comprises a light emitting unit 1, a mask 4 and a complementary color film layer 6. The light emitting unit 1 can be one or more LEDs, which are packed or epitaxial die, and the light emitting unit 1 can be a point light source or a surface light source. The mask 4 comprises a hollow portion 42, and the hollow portion 42 contains the light emitting unit 1. In another embodiment, the mask 4 can comprise a lens to enhance its directivity. The complementary color film layer 6 is uniformly attached to an inner edge of the mask 4, and the complementary color film layer 6 can be formed by coating, deposition or spraying of a plurality of fluorescent particles 62, or can be a transparent colloid comprising distribution of a plurality of fluorescent particles 62. The light emitting unit 1 generates a first wavelength light λa, and one part of the first wavelength light λa passes through the complementary color film layer 6 to generate a second wavelength light λb (not shown in the figure). The other part of the first wavelength light λa and the second wavelength light λb can be color mixed to generate white light λw. For example, the first wavelength light λa generated by the light emitting unit 1 can be blue light, and the fluorescent particles 62 can generate the second wavelength light λb in yellow color, thus the complementary color light source device 2 would generate white light λw by mixing yellow color light(λb) and the blue color light(λa).

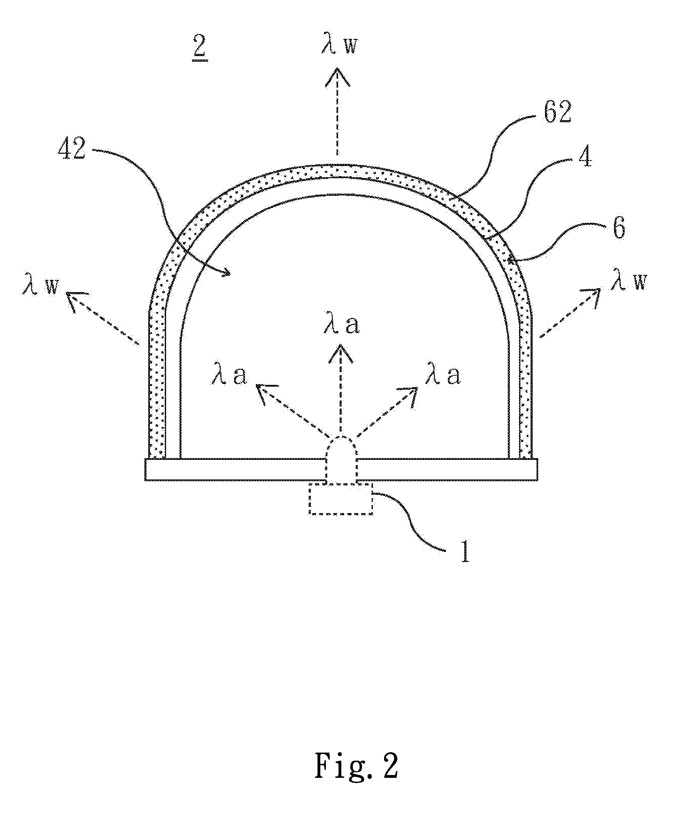

Furthermore, the complementary color film layer 6 can be attached or pasted on an inner edge or an outer edge of the mask 4, as shown corresponding to Fig. 1 and Fig. 2. In other words, the complementary color film layer 6 can be provided on either side of the mask 4 to achieve the objectives to transform a part of the first wavelength light λa generated by the light emitting unit 1 to the second wavelength light λb. And white light λw is generated by mixing the other part of the first wavelength light λa and the second wavelength light λb.

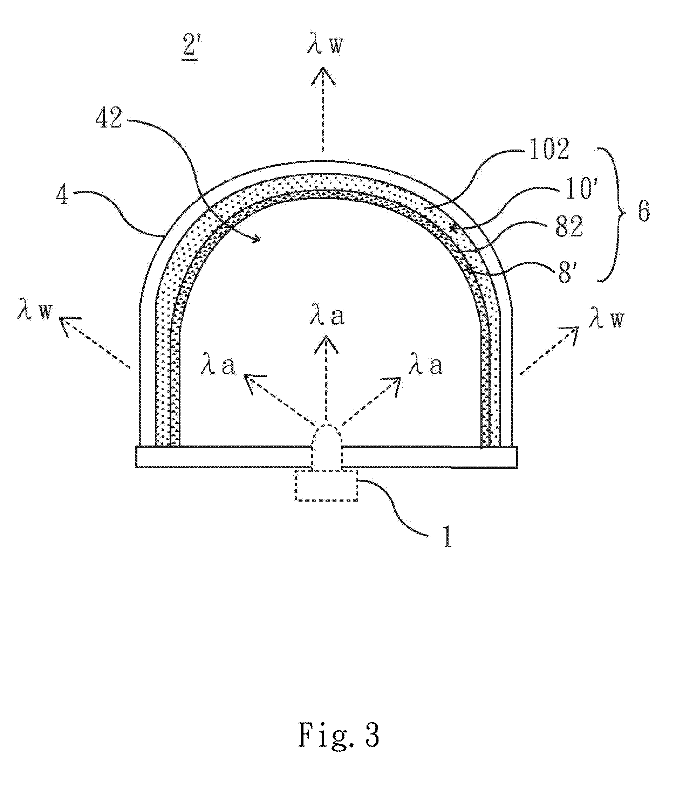

Referring to Fig. 3, which is a schematic view of a complementary color light source device according to a further embodiment of the invention. In Fig. 3, the complementary color light source device 2' comprises a light emitting unit 1, a mask 4 and a complementary color film layer 6, and the complementary color film layer 6 is formed by a plurality of thin film layers 8 and 10 (not shown in the figure). For example, the thin film layers can be red film layers 8 and green film layers 10 to form the complementary color film layer 6 of yellow; or the complementary color film layer 6 can comprise transparent colloids 8', 10' respectively comprising a plurality of fluorescent particles 82, 102 distributed among the respective transparent colloids 8', 10', and are attached in stack or respectively on an inner edge of the mask 4. It is noteworthy that the fluorescent particles 82 and 102 can be particles with different characteristics, and a combination of the fluorescent particles 82 and 102 can provide the light emitting unit 1 to generate the second wavelength light λb (not shown in the figure).

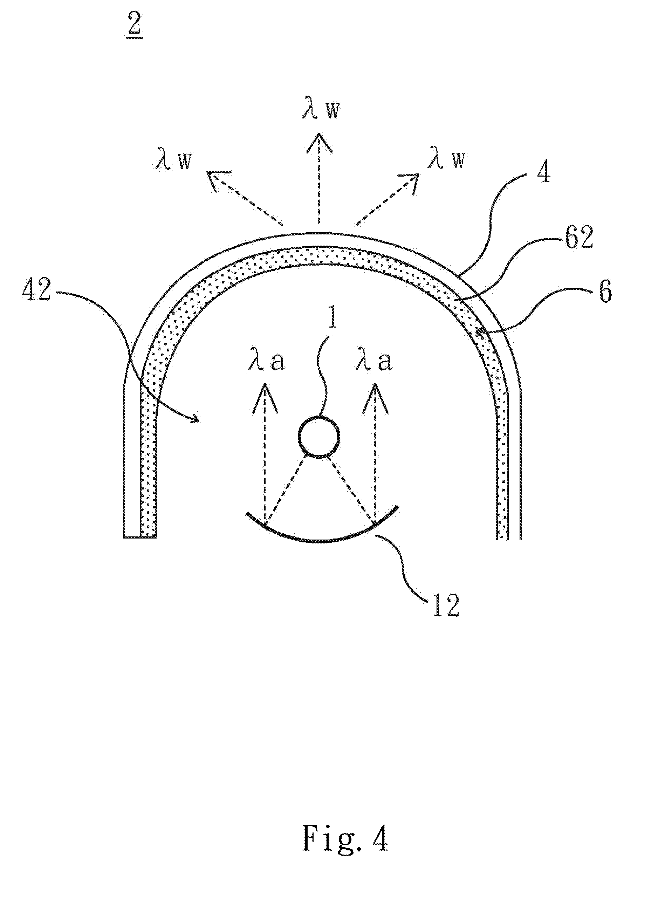

In addition, in the aforementioned embodiments, the light emitting unit 1 can be contained directly (as shown in Fig. 1 to Fig. 3) or indirectly (as shown in Fig. 4) in the hollow portion 42. Thus, the first wavelength light λa generated by the light emitting unit 1 can be directly incident to the mask 4 and the complementary color film layer 6; or the first wavelength light λa generated by the light emitting unit 1 can be indirectly incident to the mask 4 and the complementary color film layer 6 by reflection, refraction or diffraction.

Referring to Fig. 4, which is a schematic view of a complementary color light source device according to another embodiment of the invention. In Fig. 4, the light emitting unit 1 is a point light source and generates a first wavelength light λa. The light emitting unit 1 is disposed on a focus point of the light concentrating unit 12. Thus, the optical path of the first wavelength light λa can be changed by reflection of the light concentrating unit 12 to be a parallel light and incident to the mask 4 and the complementary color film layer 6. In Fig. 4, there can be a plurality of the light concentrating units 12.

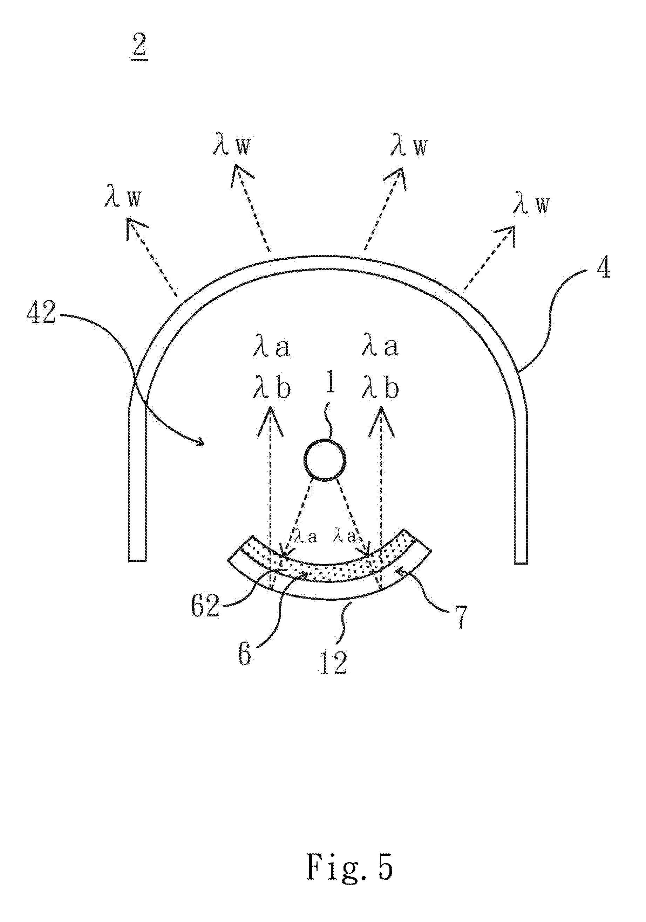

Referring to Fig. 5, which is a schematic view of a complementary color light source device according to a further embodiment of the invention. In Fig. 5, the light concentrating unit 12 comprises a reflective layer 7 and a complementary color film layer 6, and the light emitting unit 1 is disposed on a focus point of the light concentrating unit 12. Using a point light source as an example, when the light emitting unit 1 generates a first wavelength light λa, the first wavelength light λa is incident to the complementary color film layer 6 of the light concentrating unit 12. And a part of the first wavelength light λa is activated to generate a second wavelength light λb. The second wavelength light λb and the other part of the first wavelength light λa then pass through the reflective layer 7 to become parallel lights and generate the white light λw, thus incident to the mask 4. In Fig. 5 there can be a plurality of the light concentrating unit 12.

Comparing to the related arts, the complementary color light source device 2 of the invention provides the mask 4 with the complementary color film layer 6 to the light emitting unit 1, and does not require packing the light emitting unit 1 together with fluorescent particles in a packaging process. The invention can be utilized in a light emitting unit 1 which is packed or epitaxial die and belongs to secondary optical elements of packed LEDs. In addition, there is no need to pack the fluorescent particles and sealing glue together with the light emitting unit 1. One part of the first wavelength light λa generated by the light emitting unit 1 can be transformed to the second wavelength light λb, and white light λw is generated by mixing the second wavelength light λb and the other part of the first wavelength light λa. Since the complementary color film layer 6 is distant from the packing layer of the light emitting unit 1, the fluorescent particles of the complementary color film layer 6 do not become deteriorated due to the high heat generated by the light emitting unit 1, and the light emission efficiency of the white light λw will increase after color mixing. Thus, comparing to the related arts, the invention has the advantage of low cost, high light emission efficiency, high service life and high color rendering index.

The preferred embodiments of the present invention have been disclosed in the examples. However, the examples should not be construed as a limitation on the actual applicable scope of the invention, and as such, all modifications and alterations without departing from the spirit of the invention and appended claims shall remain within the protected scope and claims of the invention.

## Claims

1. A complementary color light source device, comprising:
a light emitting unit configured to generate a first wavelength light, the light emitting unit being packed or epitaxial die;
a mask comprising a hollow portion containing the light emitting unit; and
a complementary color film layer uniformly attached to a side of the mask, and a part of the first wavelength light generated by the light emitting unit passing through the complementary color film layer to generate a second wavelength light;
wherein the second wavelength light has the complementary color of the first wavelength light.

2. The complementary color light source device according to claim 1, wherein the mask comprises a lens.

3. The complementary color light source device according to claim 1, wherein the complementary color film layer is formed by coating, deposition or spraying of a plurality of fluorescent particles.

4. The complementary color light source device according to claim 1, wherein the complementary color film layer is a transparent colloid comprising a plurality of fluorescent particles distributed among the transparent colloid.

5. The complementary color light source device according to claim 3, wherein the fluorescent particles being provided to the part of the first wavelength light forming the complementary color, and white light is generated by mixing the second wavelength light and the other part of the first wavelength light.

6. The complementary color light source device according to claim 4, wherein the fluorescent particles being provided to the part of the first wavelength light forming the complementary color, and white light is generated by mixing the second wavelength light and the other part of the first wavelength light.

7. The complementary color light source device according to claim 1, wherein the first wavelength light is blue light and the second wave length light is yellow light.

8. The complementary color light source device according to claim 1, wherein the complementary color film layer is attached or pasted on an inner edge or an outer edge of the mask.

9. The complementary color light source device according to claim 1, wherein the light emitting unit is a point light source or a surface light source.

10. The complementary color light source device according to claim 1, wherein the complementary color film layer is formed by a plurality of thin film layers.

11. The complementary color light source device according to claim 10, wherein the thin film layers are red film layers and green film layers.

12. The complementary color light source device according to claim 10, wherein the thin film layers are transparent colloids respectively comprising a plurality of fluorescent particles distributed among the respectively transparent colloid, and are attached in stack or respectively on an inner edge and/or an outer edge of the mask.

13. The complementary color light source device according to claim 12, wherein the fluorescent particles are particles with different characteristics, and a combination of the fluorescent particles provides the light emitting unit to generate the second wavelength light.

14. A complementary color light source device, comprising:
a light concentrating unit;
a light emitting unit configured to generate a first wavelength light, the light emitting unit being packed or epitaxial die and disposed on a focus point of the light concentrating unit;
a mask comprising a hollow portion containing the light emitting unit; and
a complementary color film layer being uniformly attached to a side of the mask, wherein, one part of the first wavelength light generated by the light emitting unit passes through the complementary color film layer to generate a second wavelength light, and white light is generated by mixing the other part of the first wavelength light and the second wavelength light.

15. A complementary color light source device, comprising:
a light concentrating unit;
a light emitting unit configured to generate a first wavelength light, the light emitting unit being packed or epitaxial die and disposed on a focus point of the light concentrating unit; and
a mask comprising a hollow portion containing the light emitting unit;
wherein the light concentrating unit comprises a reflective layer and a complementary color film layer, the complementary color film layer is uniformly attached to a side of the mask, one part of the first wavelength light generated by the light emitting unit passes through the complementary color film layer to generate a second wavelength light, and white light is generated by mixing the other part of the first wavelength light and the second wavelength light.
